# EUROPEAN PATENT APPLICATION

(11) **EP 2 887 554 A1**
(43) Date of publication of application: **24.06.2015**
(21) Application number: 12883199.7
(22) Date of filing: 20.08.2012
(51) Int. Cl.: H03M 7/40

(54) **STORAGE PROGRAM, STORAGE METHOD, STORAGE DEVICE, DECOMPRESSION PROGRAM, DECOMPRESSION METHOD, AND DECOMPRESSION DEVICE**

(71) Applicant: Fujitsu Limited, Kawasaki-shi, Kanagawa 211-8588 (JP)
(72) Inventor: KATAOKA, Masahiro, Kawasaki-shi Kanagawa 211-8588 (JP)
(74) Representative: Hoffmann Eitle
(86) International application number: PCT/JP2012/005206
(87) International publication number: WO 2014/030180

(57) **Abstract**

One aspect is to reduce the size of compression dictionary data used in a compression process.

According to one mode, compression dictionary data is generated by causing a computer, which performs the compression process, to store character data to be compressed and code length of a compressed code assigned to the character data in respective storing places specified by a plurality of types of predetermined-length bit strings including the compressed code within a storage area where the storing places are specified by the predetermined-length bit strings.

## Description

### Field

The present invention relates to a data compression/decompression technology.

### Background

In a compression/decompression algorithm called Huffman coding, relationship between each symbol (a character or the like) included in data to be compressed and a compressed code assigned to the symbol is indicated by a binary tree structure. This binary tree is called a Huffman tree. Data of each leaf part (trailing end) of the Huffman tree indicates a symbol, and a compressed code corresponding to the symbol indicates a search path from a root (starting end) to the leaf of the Huffman tree. In a decompression process using Huffman coding, a search for a Huffman tree is performed by repeating the readout of 1-bit data from compressed data and the determination of a branch (a root or node part of a tree structure) in the Huffman tree corresponding to the read data. By performing the search for the Huffman tree, a symbol corresponding to a bit string (i.e., a compressed code) in the compressed data is identified.

In the compression/decompression algorithm for Huffman coding, a data structure including a plurality of pieces of information indicating a reference destination (such as a pointer; hereinafter, referred to as a pointer) and decompressed character codes is included in each of data structures of the Huffman tree. The determination of a branch in the search for the Huffman tree is performed by selecting a pointer indicating the next reference destination according to a bit read out from the compressed data. That is, which of a plurality of pointers included in a data structure of each branch is used is determined according to a bit read out from the compressed data. A data structure to be referenced next is indicated by a pointer corresponding to the bit read out from the compressed data. In a data structure subject to the determination according to the final bit of a compressed code, a data structure of a leaf indicating a symbol corresponding to the compressed code is stored.

Meanwhile, there is a technology to read out predetermined-length bit strings from compressed data and identify decompressed character data on the basis of the read bit strings (for example, Patent Literature 1). In Huffman coding, the code length of a compressed code is set according to the frequency of appearance, so there exists a compressed code of which the code length is less than a predetermined length. Therefore, correspondence relationship between decompressed character data and compressed code is indicated by a predetermined-length bit string that an extra bit has been added to the compressed code and an associated pointer to a data structure including the decompressed character data. Predetermined-length bit strings that a different bit has been added to the same compressed code are associated with the same pointer. In a decompression process using this algorithm, a predetermined-length bit string including an extra bit is read out from compressed data, and a pointer is acquired on the basis of the read predetermined-length bits, and decompressed character data is read out on the basis of the acquired pointer. Furthermore, the readout position at which a predetermined-length bit string is read out from the compressed data next is set to the position advanced by bits of the compressed code length from the last readout position. Accordingly, based on the compression/decompression algorithm for assigning a compressed code with a code length according to the frequency of appearance, the decompression process is performed on the basis of the bits read out from the compressed data.

In the above-described technology, a decompressed character string is acquired from bit strings read out from compressed data; therefore, the same pointer is redundantly stored in each of bit strings that a different bit has been added to the same compressed code.

### Citation List

### Patent Literature

Patent Literature 1: Japanese Laid-open Patent Publication No. 2010-93414
Patent Literature 2: International Publication Pamphlet No. WO 2008/142800

### Summary

### Technical Problem

According to the technology described above, two reference processes, i.e., reference of a pointer based on a read bit string and reference of decompressed character data based on the pointer arise in a decompression process.

One aspect of the present invention is to reduce an amount of decompression process.

### Solution to Problem

According to one aspect, a storage program causes a computer to execute: storing character data to be compressed in respective storing places specified by a plurality of types of predetermined-length bit strings including a compressed code assigned to the character data within a storage area where the storing places are specified by the predetermined-length bit strings.

According to one aspect, a storage method is for causing a computer to execute: storing character data to be compressed in respective storing places specified by a plurality of types of predetermined-length bit strings including a compressed code assigned to the character data within a storage area where the storing places are specified by the predetermined-length bit strings.

According to one aspect, a storage device includes: a storage unit that includes a storage area where a storing place is specified by a predetermined-length bit string; and a control unit that stores character data to be compressed in respective storing places specified by a plurality of types of predetermined-length bit strings including a compressed code assigned to the character data within the storage area.

According to one aspect, a decompression program causes a computer to execute: when a plurality of types of predetermined-length bit strings including a common compressed code are read out from a storage area where decompressed character data corresponding to the compressed code and code length of the compressed code have been stored in respective storing places specified by the predetermined-length bit strings including the compressed code from readout position in a compressed file, reading out the decompressed character data and the code length from a storing place specified by a read predetermined-length bit string; converting the predetermined-length bit string read out from the compressed file into the decompressed character data; and adjusting the readout position on the basis of the code length.

According to one aspect, a decompression method is for causing a computer to execute: when a plurality of types of predetermined-length bit strings including a common compressed code are read out from a storage area where decompressed character data corresponding to the compressed code and code length of the compressed code have been stored in respective storing places specified by the predetermined-length bit strings including the compressed code from readout position in a compressed file, reading out the decompressed character data and the code length from a storing place specified by a read predetermined-length bit string; converting the predetermined-length bit string read out from the compressed file into the decompressed character data; and adjusting the readout position on the basis of the code length.

According to one aspect, a decompression device includes: a storage unit that includes a storage area where decompressed character data corresponding to a common compressed code and code length of the compressed code have been stored in respective storing places specified by a plurality of types of predetermined-length bit strings including the compressed code; a readout unit that reads, when the predetermined-length bit strings including the compressed code are read out from readout position in a compressed file, the decompressed character data and the code length from a storing place specified by a read predetermined-length bit string out to the storage unit; a converting unit that converts the predetermined-length bit string read out from the compressed file into the decompressed character data; and an adjusting unit that adjusts the readout position on the basis of the code length.

### Advantageous Effects of Invention

According to one aspect of the present invention, it is possible to reduce an amount of decompression process.

### Brief Description of Drawings

FIG. 1 illustrates an example of a Huffman tree.
FIG. 2 illustrates reference relationship between data structures.
FIG. 3 illustrates an example of a data structure of a compression/decompression dictionary.
FIG. 4 illustrates an example of a modified Huffman tree.
FIG. 5 illustrates an example of a data structure of a compression/decompression dictionary.
FIG. 6 illustrates an example of a modified data structure of the compression/decompression dictionary.
FIG. 7 illustrates a configuration example of a functional block of a computer 1.
FIG. 8 illustrates a hardware configuration example of the computer 1.
FIG. 9 illustrates a software configuration example of the computer 1.
FIG. 10 illustrates a configuration example of a system using the computer 1.
FIG. 11 illustrates an example of a flowchart of a compression process performed by a compression unit 101.
FIG. 12 illustrates an example of a flowchart of a process of generating compression/decompression dictionary data.
FIG. 13 illustrates an example of a frequency tabulation table T7.
FIG. 14 illustrates an example of a character-string list T8.
FIG. 15 illustrates an example of a code-length distribution table T9.
FIG. 16 illustrates an example of a flowchart of a conversion process.
FIG. 17 illustrates an example of a flowchart of a decompression process performed by a decompression unit 102.
FIG. 18 illustrates an example of a flowchart of a conversion process.
FIG. 19 illustrates an example of a flowchart of a retrieval process performed by a retrieval unit 103.
FIG. 20 illustrates an example of compression/decompression dictionary data T10.
FIG. 21 illustrates an example of a flowchart of a cross-checking process.

### Description of Embodiments

First, a compression/decompression process using Huffman coding and a modified example are explained.

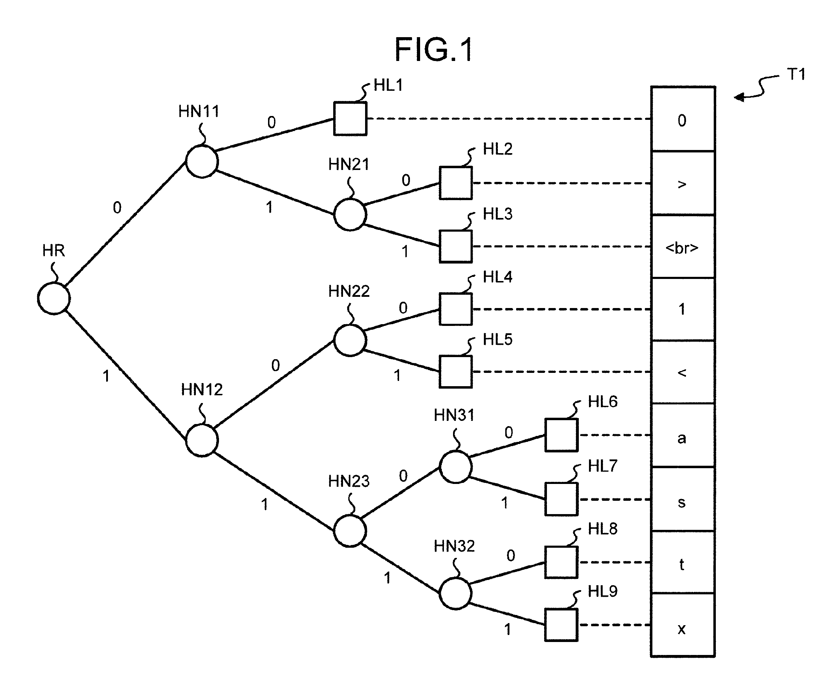

FIG. 1 illustrates an example of a Huffman tree. The Huffman tree illustrated in FIG. 1 represents correspondence relationship between character data (0, >, <br>, 1, <, a, s, t, x) and compressed code.

The character data (0, >, <br>, 1, <, a, s, t, x) is just an example of character data used for explanation of the Huffman tree. As character data to be compressed, for example, a character code, such as a number, an alphabet, a hiragana character, a katakana character, a kanji character, an Arabic alphabet, a Cyrillic alphabet, or a symbol (two-byte or one-byte), a character string (a reserved word) composed of a combination of a plurality of characters, and a fixed-length bit string, etc. are used. A list T1 illustrated in FIG. 1 is a list of pieces of character data to be compressed sorted according to the frequency of appearance in compressed target data. Furthermore, out of the pieces of character data to be compressed, character data of which the bit length is not the same as a character code (in the example of FIG. 1, a reserved word "<br>", etc.) is managed by further using a list other than the list T1. The pieces of character data in the list T1 are stored in data structures HL (HL1 to HL9) of leaves of the Huffman tree, respectively.

The correspondence relationship between each piece of the character data in the list T1 and a compressed code is indicated by a search path from a data structure HR of a root of the Huffman tree to a data structure HL (HL1 to HL9) of a leaf. In each of the data structure HR of the root and data structures HN (HN11, HN12, HN21 to HN23, HN31, and HN32) of nodes, there are branches depending on whether a bit is "0" or "1", and a compressed code is indicated by a bit used in a branch on a search path. Furthermore, in Huffman coding, the higher the frequency of appearance of character data is, the shorter length of a compressed code is assigned to the character data; the lower the frequency of appearance of character data is, the longer length of a compressed code is assigned to the character data. For example, a compressed code of the character data "t" is indicated by a search path to the data structure HL8 of the leaf in which the character data "t" has been stored. A search from the root HR to the data structure HL8 is made by sequentially tracing a path from the root HR to the node HN12 indicated by a bit "1", a path from the node HN12 to the node HN23 indicated by a bit "1", a path from the node HN23 to the node HN32 indicated by a bit "1", and a path from the node HN32 to the leaf HL8 indicated by a bit "0". In FIG. 1, "1110", which is a string of the bits indicating the paths included in the search path from the root HR to the data structure HL8 of the leaf, is a compressed code assigned to the character data "t".

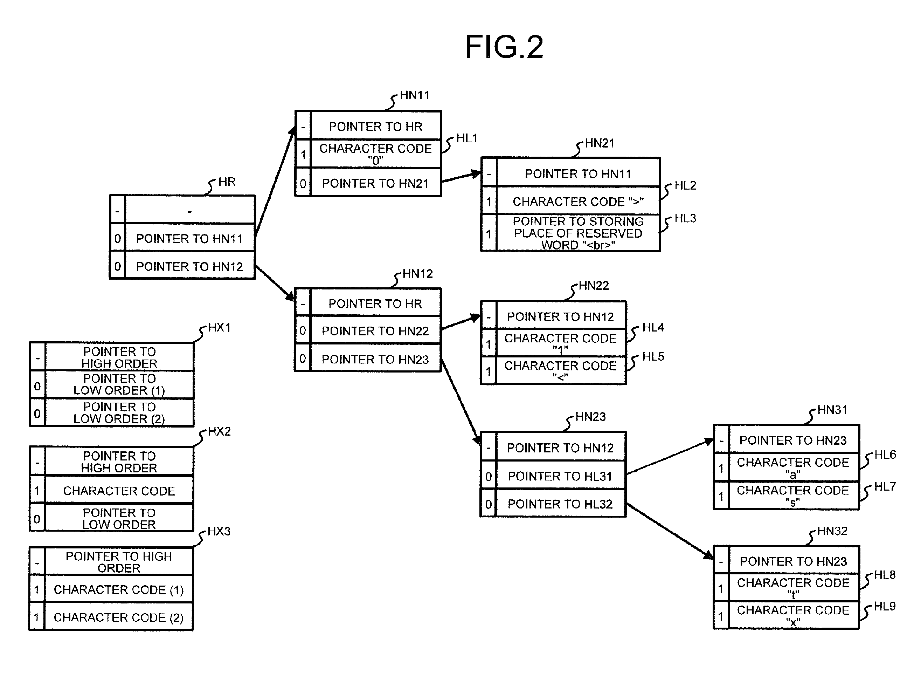

FIG. 2 illustrates reference relationship between data structures. The search explained with FIG. 1 is made by using the relationship of pointer reference illustrated in FIG. 2. Explanatory notes of the data structure HR of the root and the data structures HN of the nodes are indicated in HX1 to HX3. The explanatory note HX1 includes a pointer to a high-order data structure, a first identifier ("0" in FIG. 2) indicating that a pointer has been stored, the pointer to a (first) low-order data structure, a second identifier ("0" in FIG. 2) indicating that a pointer has been stored, and the pointer to a (second) low-order data structure. The explanatory note HX2 includes a pointer to a high-order data structure, an identifier ("1" in FIG. 2) indicating that a character code has been stored, the character code, an identifier ("0" in FIG. 2) indicating that a pointer has been stored, and a pointer to a low-order data structure. The explanatory note HX3 includes a pointer to a high-order data structure, an identifier ("1" in FIG. 2) indicating that a (first) character code has been stored, the (first) character code, an identifier ("1" in FIG. 2) indicating that a (second) character code has been stored, and the (second) character code. The data structure of the root and the data structures HN of the nodes are a data structure in any of the explanatory notes HX1 to HX3. Furthermore, not a character code but a pointer indicating a storing place in which a character code of a character string (a reserved word) has been stored may be stored in a data structure of a leaf. This pointer indicates a storing place of a corresponding character string in a list T8 to be described later. On the basis of an identifier read out from a data structure, whether information read out from the data structure is a pointer or a character code is determined. For example, an offset to read out a pointer to a (first) identifier and an offset to read out a pointer to a (second) identifier are determined in advance. For example, when respective storing places of a pointer and identifier or a character code and identifier stored in a data structure are 32 bits, and a read bit is x, an offset to read out an identifier is calculated by 32×(1+x).

In a decompression process, character data corresponding to a compressed code is read out on the basis of the compressed code. For example, when a bit read out from compressed data is "0", a (first) low-order data structure is referenced; when the bit is "1", a (second) low-order data structure is referenced. Then, a data structure to be referenced next is identified by using a pointer corresponding to the bit read out from the compressed data. For example, assume that data has been read out from the compressed data in the order of "1110...". Then, a pointer to a (second) low-order data structure in the data structure HR of the root is a pointer to the data structure HN12 of the node, and the data structure HN12 of the node is referenced on the basis of the pointer. Furthermore, a pointer to a (second) low-order data structure in the data structure HN12 of the node is a pointer to the data structure HN23 of the node, and the data structure HN23 of the node is referenced on the basis of the pointer. A pointer to a (second) low-order data structure in the data structure HN23 of the node is a pointer to the data structure HN32 of the node, and the data structure HN32 of the node is referenced on the basis of the pointer. A character code has been stored in the data structure HN32 of the node, and the fourth compressed code is "1", so the data structure HL8 of the leaf in which the character data "t" corresponding to the compressed code "1110" has been stored is referenced. In a data structure of a leaf, an identifier ("1" in FIG. 2) indicating that information included in the data structure is a character code is added; therefore, it is determined that not a pointer but the character code has been acquired on the basis of the identifier.

On the other hand, in a compression process, a compressed code is read out on the basis of character data. The compressed code is obtained from a data structure of a leaf in which the character data has been stored by reference to the data structure on the basis of a pointer to a high-order data structure. However, in the compression process, for example, instead of tracing a Huffman tree, a method to generate a table in which character data and a compressed code are associated and acquire the compressed code on the basis of the generated table can be used.

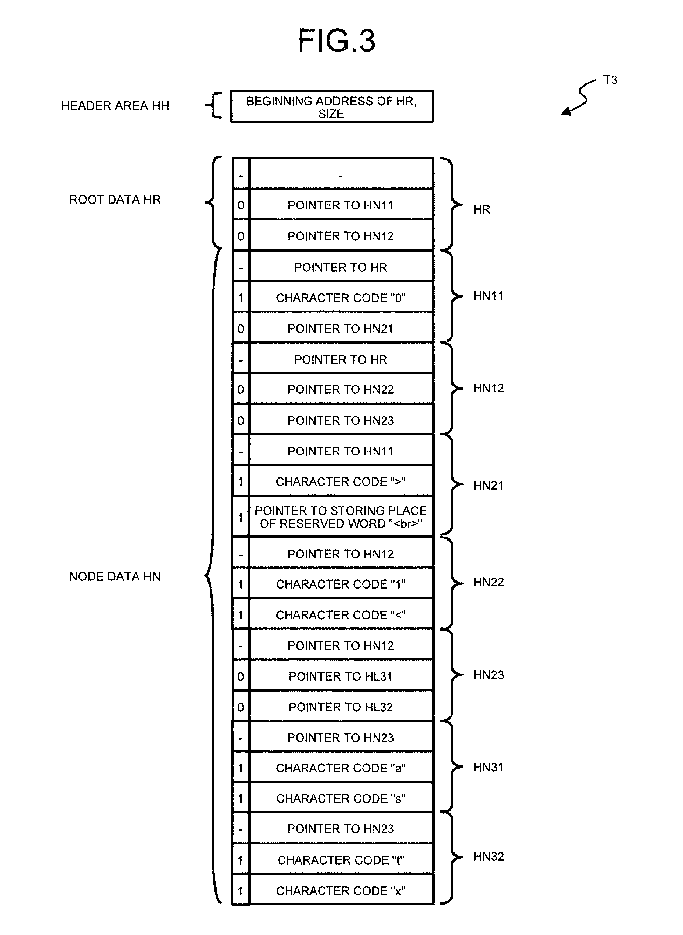

FIG. 3 illustrates an example of a data structure T3 of a compression/decompression dictionary. The compression/decompression dictionary illustrated in FIG. 3 includes a data structure HH of a header area, a data structure HR of a root, and data structures HN of nodes. The data structure HH of the header area includes information on the data structure HR of the root and the data structures HN of the nodes. The data structure HH includes a beginning address on memory space of the data structure HR of the root and the data size of the data structure HR of the root and the data structures HN of the nodes.

In the example of FIG. 3, the data structure HR of the root and the data structures HN (HN11, HN12, HN21 to HN23, HN31, and HN32) of the leaves illustrated in FIG. 2 are stored successively. When data structures are in succession as illustrated in FIG. 3, pointers included in the data structure HR of the root and the data structures HN of the nodes can be an offset from the beginning address stored in the header area HH. For example, when the data size of the data structure HR of the root and the data structures HN of the nodes is 32x3 bits, a pointer to the data structure HN21 of the node is indicated by 32x3x3. Then, it can be determined that the data structure HN21 of the node exists at the location corresponding to the offset of 32x3x3 from the beginning address.

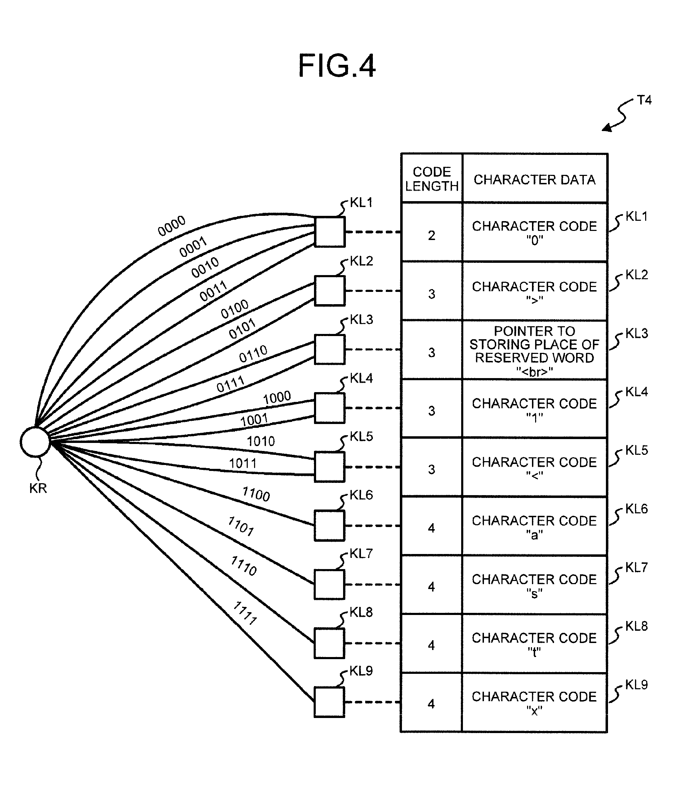

FIG. 4 illustrates an example of a modified Huffman tree. Also in FIG. 4, just like FIG. 1, 0, >, <br>, 1, <, a, s, t, x are an example of character data to be compressed. Furthermore, also in the modified Huffman tree illustrated in FIG. 4, the same compressed codes as the Huffman tree illustrated in FIG. 1 are assigned to the pieces of character data. In FIG. 4, character data and the code length of a compressed code assigned to the character data are stored in data structures KL (KL1 to KL9) of leaves. Contents of the data structures KL of the leaves are as indicated in a table T4 in FIG. 4.

In the modified example illustrated in FIG. 4, the determination of a branch in a data structure KR of a root is performed on the basis of a bit string of 4 bits. In the example of FIG. 4, a branch is determined by a bit string of 4 bits; however, of course, the determination can be modified to be performed by a bit string of bits other than 4 bits according to the number of types of character data to be compressed. For example, when a bit string "0100" has been read out from compressed data, the data structure KL2 of the leaf is read out. Furthermore, also when a bit string "0101" has been read out from the compressed data, the data structure KL2 of the leaf is read out. That is, in the determination of a branch in the data structure KR of the root, in either case where any of the different bit strings "0100" and "0101" has been read out, a pointer to the data structure KL2 of the same leaf is read out, and the readout of the data structure of the leaf is performed on the basis of the pointer.

Furthermore, in spite of the readout of 4 bits from the compressed data, a compressed code corresponding to the character data ">" stored in the data structure KL2 of the leaf is "010". Therefore, the position to read out a bit from the compressed data is advanced by not the actually-read 4 bits but 3 bits according to the length of the code stored in the data structure KL2 of the leaf. Accordingly, the bit read out from the compressed data in surplus to the actually-assigned compressed code is adjusted. Also in the data structure KR of the root, just like the Huffman tree illustrated in FIG. 2, an offset to read out a pointer is determined according to a read bit string.

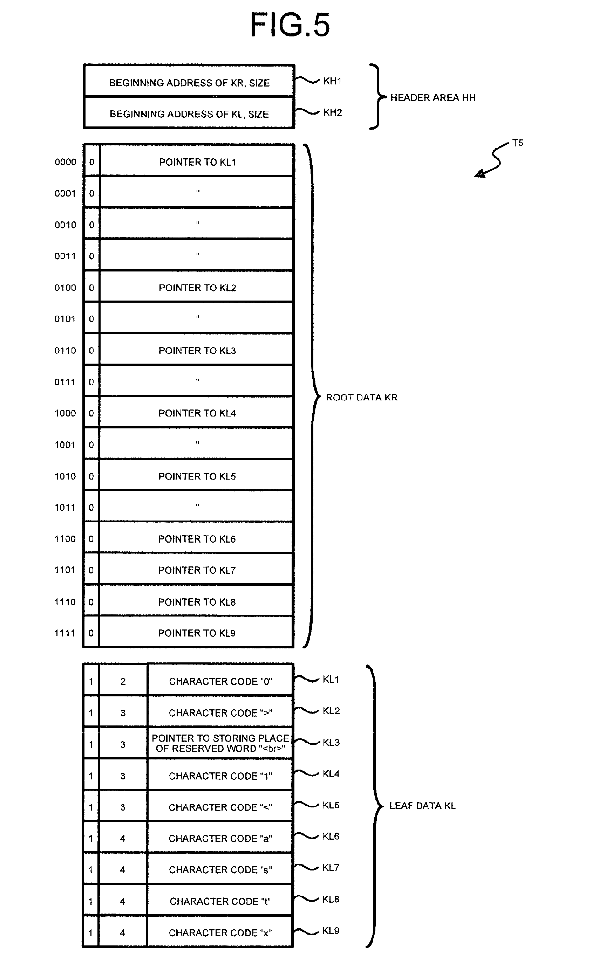

FIG. 5 illustrates an example of a data structure of compression/decompression dictionary data T5 in the modified Huffman tree illustrated in FIG. 4. The compression/decompression dictionary data T5 includes a header area HH (including a data structure KH1 of a header and a data structure KH2 of a header), a data structure KR of a root, and data structures KL (KL1 to KL9) of leaves. The data structure KH1 of the header includes a beginning address of the data structure KR of the root on memory space and the data size of the data structure KR of the root. The data structure KH2 of the header includes beginning addresses of data structures KL of leaves on memory space and the data size of the data structures KL of the leaves.

In the data structure KR of the root of the compression/decompression dictionary data T5, pointers to the data structures of the leaves are stored in the offset positions determined on the basis of 4-bit bit strings "0000" to "1111", respectively. When the size of a pointer to a data structure of a leaf is 32 bits, an offset is indicated by, for example, the position of the 4-bit bit string × 32 from the start point of the data structure T5. A pointer to a data structure of a leaf storing therein character data of which the compressed code length is shorter than 4 bits is stored in a plurality of locations. For example, a compressed code "010" has been assigned to the character data ">", and the compressed code length is 1 bit short of 4 bits. In this case, the pointer to the data structure KL2 of the leaf storing therein the character data ">" is stored in locations specified by 4-bit bit strings "0100" and "0101" obtained by adding 1 bit redundantly to the compressed code "010". In this way, by storing a pointer to a data structure of a leaf redundantly, the readout of character data based on read bit strings is performed.

The data structures KL of the leaves of the compression/decompression dictionary data T5 include a character code to be compressed and the code length of a compressed code assigned to the character code. Furthermore, the data structures KR of the roots each include an identifier indicating that a pointer has been stored therein, and the data structures KL of the leaves each include an identifier indicating that a character code has been stored therein.

In the modified examples of FIGs. 4 and 5, with respect to a pair of character data and a compressed code assigned to the character data, the same pointer is stored in a plurality of locations, thereby a pointer can be identified on the basis of read bit strings.

In the modified Huffman trees illustrated in FIGs. 4 and 5, a pointer to a data structure of a node is not included. Therefore, there is no data structure including both pointers to data structures of nodes and pointers to data structures of leaves. Therefore, for example, even if information included in a data structure of a leaf, such as character data and the compressed code length, is stored instead of a pointer to the data structure of the leaf, a situation where character data and a pointer are mixed in a data structure is not created. That is, even without checking contents of data structures, a character data group to be compressed can be acquired from compression/decompression dictionary data. Furthermore, the compressed code length is stored together with character data, so how many pieces of the same character data have been stored successively in a compression/decompression dictionary can be calculated on the basis of the compressed code length. Therefore, when character data is read out from the compression/decompression dictionary, it is possible to skip over redundant character data.

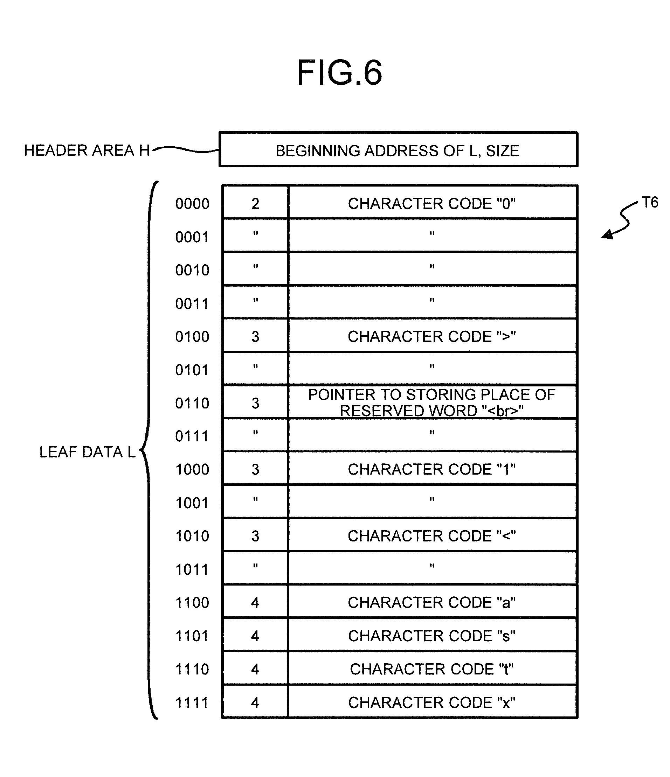

Accordingly, in the present embodiment, for example, compression/decompression dictionary data illustrated in FIG. 6 is used. Compression/decompression dictionary data T6 illustrated in FIG. 6 includes a header area H and data structures L of leaves. The header area H includes beginning addresses of the data structures L of the leaves on memory space and the data size of the data structures L of the leaves. In the data structures L of the leaves, pieces of character data corresponding to bit strings and the compressed code lengths are stored in offset positions determined on the basis of 4-bit bit strings "0000" to "1111", respectively. When the size of a data structure L is 32 bits, the position to read out a data structure of each leaf, for example, an offset from a beginning address of the data structure L of the leaf is indicated by the position of the 4-bit bit string × 32. A data structure L of a leaf storing therein character data assigned a compressed code of which the compressed code length is shorter than 4 bits is stored in a plurality of locations. For example, a compressed code "010" has been assigned to the character data ">", and the compressed code length is 1 bit short of 4 bits. In this case, the data structure of the leaf storing therein the character data ">" is stored in locations specified by 4-bit bit strings "0100" and "0101" obtained by adding 1 bit redundantly to the compressed code "010" in the compression/decompression dictionary data T6. In this way, by storing a data structure L of a leaf redundantly, the readout of character data based on read bit strings is performed.

For example, in a decompression process using the compression/decompression dictionary data T6, when a bit string including a character code has been read out, the readout of a beginning address of a data structure L of a leaf from the header area H is performed, and then the calculation of an offset from the read beginning address is performed on the basis of the read bit string. Furthermore, decompression is performed by performing the readout of character data and code length on the basis of the calculated offset. On the other hand, in a decompression process using the compression/decompression dictionary data T5, when a bit string including a character code has been read out, the readout of a beginning address of a data structure KR of a root from the data structure KH1 of the header is performed, and then the calculation of an offset from the read beginning address is performed on the basis of the read bit string. When a pointer has been read out on the basis of the calculated offset, the readout of a beginning address of a data structure KL of a leaf from the data structure KH2 of the header is further performed. The calculation of an offset from the read beginning address is performed on the basis of the read pointer, and as a result, the readout of character data and code length is performed on the basis of the calculated offset. As described above, in the decompression process using the compression/decompression dictionary data T5, the number of accesses to the header area is larger than the decompression process using the compression/decompression dictionary data T6. In the decompression process using the compression/decompression dictionary data T6, the access to the header area KH1 and the access to the data structure KR of the root, which are performed in the decompression process using the compression/decompression dictionary data T5, are not performed. Therefore, the decompression process using the compression/decompression dictionary data T6 is expected to achieve the higher decompression speed than the decompression process using the compression/decompression dictionary data T5.

Furthermore, for example, assume that the data structures of the nodes and leaves in the compression/decompression dictionary data T5 and the data structures of the leaves in the compression/decompression dictionary data T6 have the same data size. Then, the data structures L of the leaves fit into a data structure KN of a node in which a pointer is stored in the compression/decompression dictionary data T5. Therefore, the data size of the compression/decompression dictionary data T6 becomes smaller than the compression/decompression dictionary data T5 by the number of types of character data to be compressed times the data size of each data structure.

According to another aspect of the present embodiment, the pointer reference processes are suppressed, and therefore, it is possible to improve the decompression speed.

Subsequently, details of the present embodiment are explained.

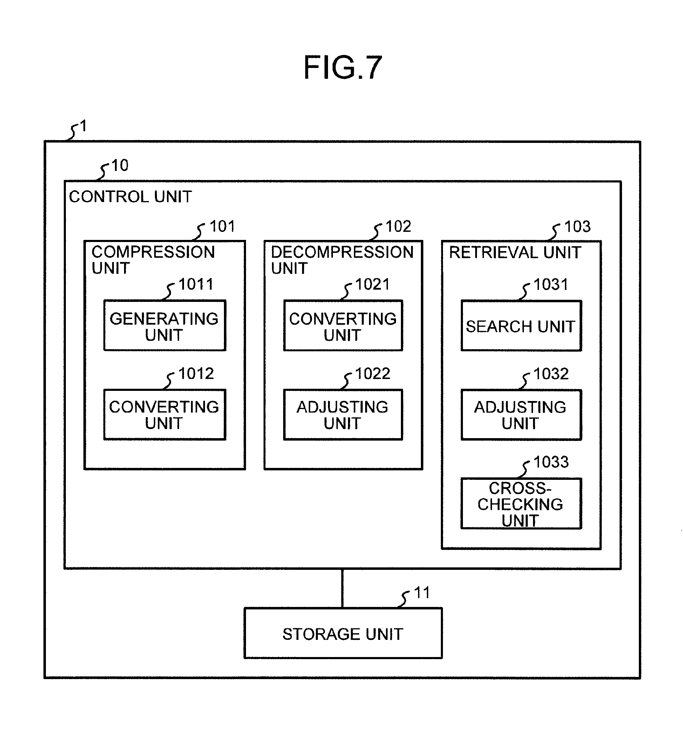

FIG. 7 illustrates a configuration example of a functional block of a computer 1. The computer 1 includes a control unit 10 and a storage unit 11. The control unit 10 controls the entire computer 1, and performs a compression process, a decompression process, and a retrieval process on data stored in the storage unit 11. The storage unit 11 stores therein data subject to the compression process, decompression process, and retrieval process performed by the control unit 10 and data used in the processes. Furthermore, the storage unit 11 is used as a work area when the control unit 10 performs the processes. For example, the storage unit 11 can reside outside of the computer 1, and the control unit 10 can access the data stored in the storage unit 11 through communication with the computer 1.

The control unit 10 includes a compression unit 101, a decompression unit 102, and a retrieval unit 103. The compression unit 101 performs a compression process on data to be compressed which has been stored in the storage unit 11; the decompression unit 102 performs a decompression process on data stored in the storage unit 11; the retrieval unit 103 performs a retrieval process of data to be retrieved which has been stored in the storage unit 11 in response to a retrieval request.

The compression unit 101 includes a generating unit 1011 and a converting unit 1012. The generating unit 1011 generates compression/decompression dictionary data illustrated in FIG. 6 on the basis of data to be compressed and a list of character data to be compressed. The converting unit 1012 converts data to be compressed into a compressed code on the basis of the compression/decompression dictionary data generated by the generating unit 1011. Details of processes performed by the generating unit 1011 and the converting unit 1012 will be described later.

The decompression unit 102 includes a converting unit 1021 and an adjusting unit 1022. The converting unit 1021 converts data to be decompressed into character data on the basis of compression/decompression dictionary data corresponding to the data to be decompressed. The adjusting unit 1022 adjusts the readout position from which the converting unit 1021 reads out data to be decompressed on the basis of compression/decompression dictionary data. Details of processes performed by the converting unit 1021 and the adjusting unit 1022 will be described later.

The retrieval unit 103 includes a search unit 1031, an adjusting unit 1032, and a cross-checking unit 1033. The search unit 1031 sets an extraction condition for extraction of an object to be cross-checked on the basis of a retrieval condition included in a retrieval request, and searches for any data which meets the extraction condition in compressed data, and decompresses the compressed data which meets the extraction condition. The adjusting unit 1032 adjusts the readout position from which the search unit 1031 reads out compressed data on the basis of compression/decompression dictionary data. The cross-checking unit 1033 cross-checks character data obtained through the decompression by the search unit 1031 with the retrieval condition. Details of processes performed by the search unit 1031, the adjusting unit 1032, and the cross-checking unit 1033 will be described later.

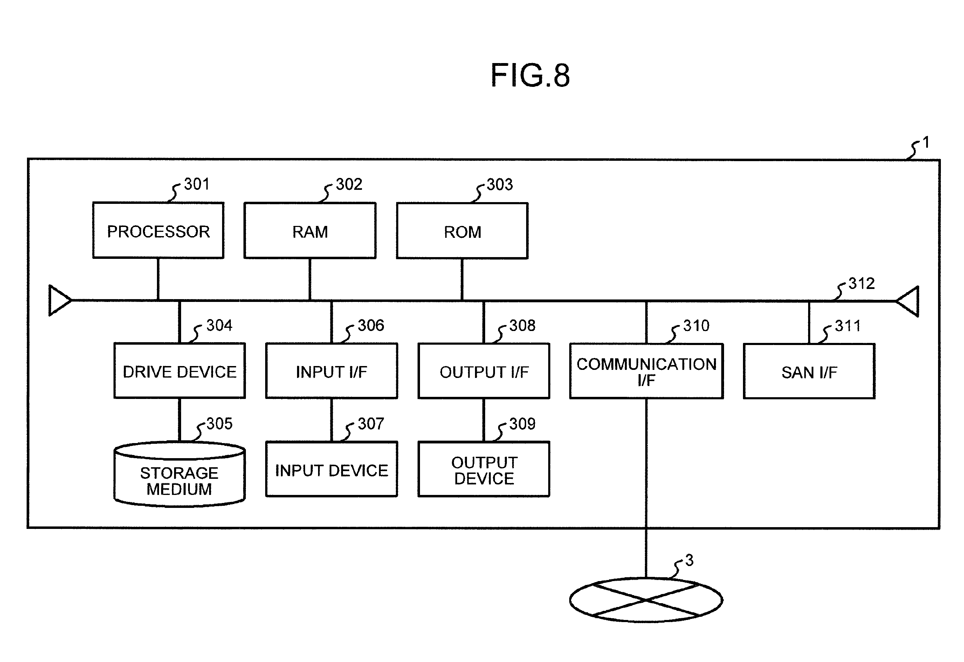

FIG. 8 illustrates a hardware configuration example of the computer 1. The computer 1 includes, for example, a processor 301, a random access memory (RAM) 302, a read only memory (ROM) 303, a drive device 304, a storage medium 305, an input interface (I/F) 306, an input device 307, an output interface (I/F) 308, an output device 309, a communication interface (I/F) 310, a storage area network (SAN) interface (I/F) 311, and a bus 312, etc. These pieces of hardware are connected through the bus 312.

The RAM 302 is a memory device capable of data read/write; for example, a semiconductor memory, such as a static RAM (SRAM) and a dynamic RAM (DRAM), or a flash memory, etc. can be used as the RAM 302 regardless of RAM or not. The ROM 303 includes a programmable ROM (PROM), etc. The drive device 304 is a device that performs at least either reading of information recorded on the storage medium 305 or writing of information on the storage medium 305. The storage medium 305 stores therein information written by the drive device 304. The storage medium 305 is, for example, a hard disk, a flash memory such as a solid state drive (SSD), or a storage medium such as a compact disc (CD), a digital versatile disc (DVD), and a Blu-ray disc. Furthermore, for example, the computer 1 is provided with the drive device 304 and the storage medium 305 with respect to each of several types of storage media.

The input I/F 306 is connected to the input device 307, and transmits an input signal received from the input device 307 to the processor 301. The output I/F 308 is connected to the output device 309, and causes the output device 309 to output according to an instruction from the processor 301. The communication I/F 310 controls communication via a network 3. The SAN I/F 311 controls communication with a storage device connected to the computer 1 via a storage area network.

The input device 307 is a device that sends an input signal according to an operation. The input signal is, for example, a keyboard, a key device such as a button installed on the main body of the computer 1, and a pointing device such as a mouse and a touch panel. The output device 309 is a device that outputs information according to control by the computer 1. The output device 309 is, for example, an image output device (a display device), such as a display, and an audio output device, such as a speaker. Furthermore, for example, an input/output device, such as a touch screen, is used as the input device 307 and the output device 309. Moreover, the input device 307 and the output device 309 can be, for example, external device that are not included in the computer 1 and are externally connected to the computer 1.

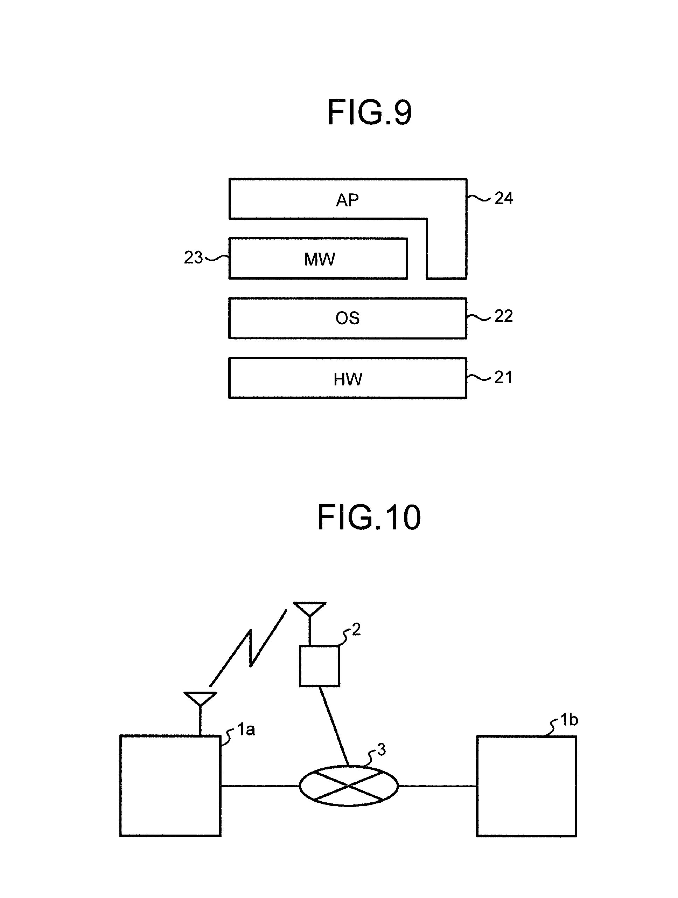

The processor 301 reads a program stored in the ROM 303 or the storage medium 305 and loads the program onto the RAM 302, and performs a process of the control unit 10 in accordance with a procedure of the read program. At this time, the RAM 302 is used as a work area of the processor 301. The function of the storage unit 11 is realized by the situation where the ROM 303 and the storage medium 305 store therein program files (an application program 24, middleware 23, and an OS 22, etc.) and data files (a data file to be compressed and a compressed file), and the RAM 302 is used as a work area of the processor 301. A program read out by the processor 301 is explained with FIG. 9.

FIG. 9 illustrates a configuration example of a program which runs on the computer 1. The operating system (OS) 22, which controls a hardware group 21 illustrated in FIG. 8, runs on the computer 1. The processor 301 operates according to the procedure in accordance with the OS 22, and controls/manages the hardware group 21, thereby the hardware group 21 performs a process according to the application program 24 or the middleware 23. Furthermore, in the computer 1, the middleware 23 or the application program 24 is loaded onto the RAM 302 and executed by the processor 301.

The processor 301 performs a process based on a compression function included in the middleware 23 or the application program 24, thereby the function of the compression unit 101 is realized (by controlling hardware 21 to perform the process on the basis of the OS 22). Furthermore, the processor 301 performs a process based on a decompression function included in the middleware 23 or the application program 24, thereby the function of the decompression unit 102 is realized (by controlling hardware 21 to perform the process on the basis of the OS 22). Moreover, the processor 301 performs a process based on a retrieval function included in the middleware 23 or the application program 24, thereby the function of the retrieval unit 103 is realized (by controlling hardware 21 to perform the process on the basis of the OS 22). The compression function, the decompression function, and the retrieval function can be defined in the application program 24, or can be functions of the middleware 23 executed by being invoked in accordance with the application program 24.

FIG. 10 illustrates a configuration example of a system using the computer 1. The system illustrated in FIG. 10 includes a computer 1a, a computer 1b, a base station 2, and a network 3. The computer 1a is connected to the network 3 connected to the computer 1b by at least either wireless or wired connection. For example, in the system illustrated in FIG. 10, the computer 1a acquires a data file compressed by the computer 1b having performed a compression process according to the present embodiment, and decompresses the compressed file acquired from the computer 1b by performing a decompression process according to the present embodiment. Conversely, for example, in the system illustrated in FIG. 10, the computer 1b acquires a data file compressed by the computer 1a having performed a compression process according to the present embodiment, and decompresses the compressed file acquired from the computer 1a by performing a decompression process according to the present embodiment. Furthermore, for example, in the system illustrated in FIG. 10, the computer 1a acquires a data file compressed by the computer 1b having performed a compression process according to the present embodiment, and retrieves the compressed file acquired from the computer 1b by performing a retrieval process according to the present embodiment. Conversely, for example, in the system illustrated in FIG. 10, the computer 1b acquires a data file compressed by the computer 1a having performed a compression process according to the present embodiment, and retrieves the compressed file acquired from the computer 1a by performing a retrieval process according to the present embodiment. Moreover, at least two of the compression process, the decompression process, and the retrieval process can be performed in the computer 1a. Furthermore, the compression process and the retrieval process can be performed in either the computer 1a or the computer 1b, and a retrieval request can be sent to one computer from the other computer.

Subsequently, the procedure of the compression process performed in the computer 1 is explained.

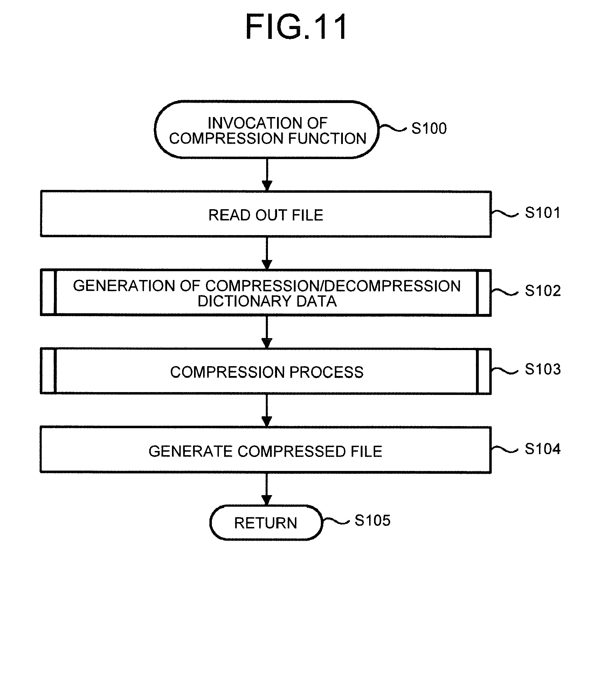

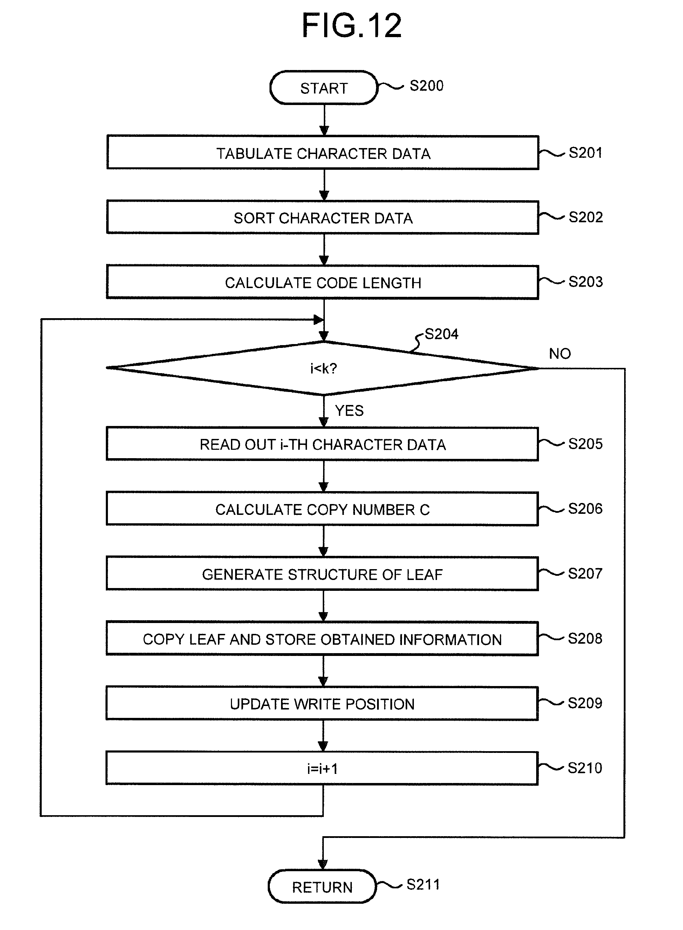

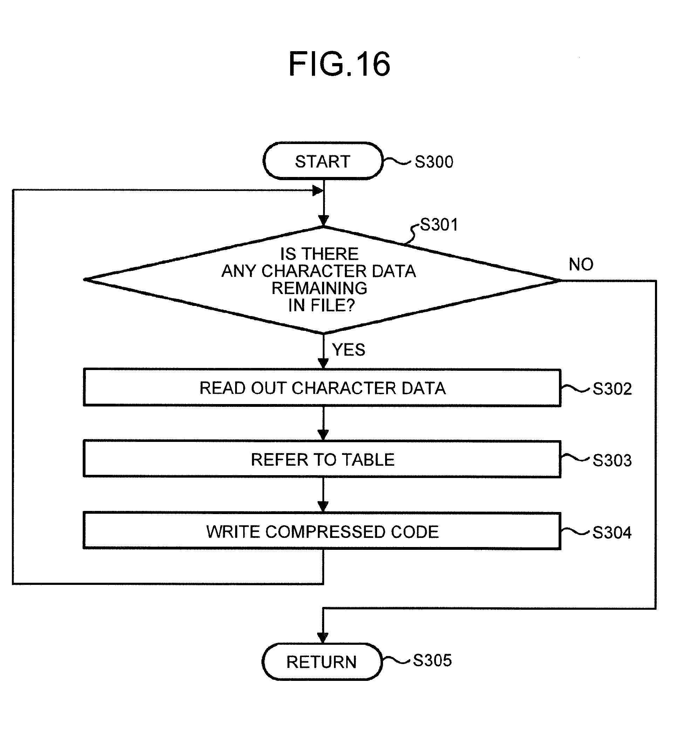

FIG. 11 illustrates an example of a flowchart of the compression process performed by the compression unit 101. When a compression processing function has been invoked in response to the function of the application program 24 or an instruction input from a user (step S100), the compression unit 101 reads out a data file to be compressed specified in the invocation of the compression processing function from the storage unit 11 (step S101). On the basis of the data file to be compressed read at step S101, the generating unit 1011 generates the compression/decompression dictionary data T6 illustrated in FIG. 6 (step S102). The generation of the compression/decompression dictionary data T6 by the generating unit 1011 will be described later with FIG. 12. Then, the converting unit 1012 converts the data file to be compressed into a compressed code on the basis of the compression/decompression dictionary data T6 generated by the generating unit 1011 (step S103). The conversion into a compressed code by the converting unit 1012 will be described later with FIG. 16. When the conversion of the data to be compressed into a compressed code by the converting unit 1012 has been performed, the compression unit 101 generates a compressed file by filing the data obtained through the conversion (step S104). When the compressed file has been obtained by the compression unit 101, the compression process invoked at step S100 is terminated (step S105).

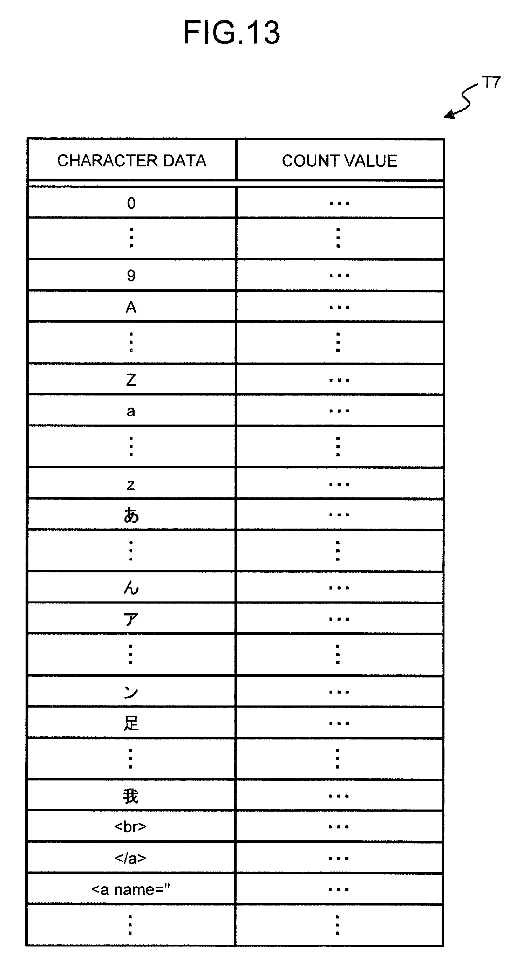

FIG. 12 illustrates an example of a flowchart of the process of generating the compression/decompression dictionary data T6. When the process at step S102 in FIG. 11 has been performed (S200), the generating unit 1011 tabulates the frequency of appearance of character data included in the data file to be compressed read out at step S101 (S201). In the process at S201, a storage area for storing the compression/decompression dictionary data is reserved, and a data structure H of a header is generated. The generating unit 1011 sequentially reads out character data from the data file to be compressed, and reflects a result of the readout in a frequency tabulation table T7 illustrated in FIG. 13.

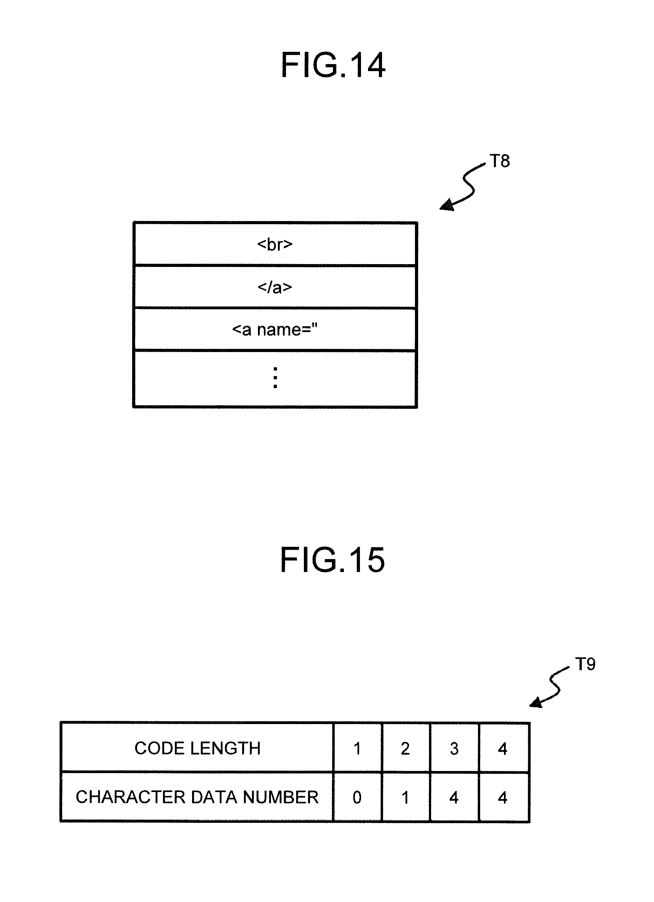

FIG. 13 illustrates an example of the frequency tabulation table T7. In the example illustrated in FIG. 13, in each of records included in the frequency tabulation table T7, character data and a count value indicating the number of appearances of the character data are stored in an associated manner. The character data stored in the frequency tabulation table T7 is, for example, at least part of characters such as a number, an alphabet, a hiragana character, a katakana character, a kanji character, an Arabic alphabet, and a Cyrillic alphabet in a character code system used in the data file to be compressed. As for the kanji character, for example, only a character code of kanji designated for everyday use can be stored in the frequency tabulation table T7. Furthermore, the character data also includes, for example, fixed-length data other than a character code. For example, a compressed code string obtained on the basis of LZ77 has the fixed length because length information of data coincident with an address in a sliding window is output as a compressed code string. In a compression algorithm such as ZIP, Huffman coding is used with respect to the fixed-length compressed code string obtained on the basis of LZ77. Moreover, the character data can include a character string. For example, the character data includes a character string included in a character-string list T8 illustrated in FIG. 14. In the present embodiment, as an example to explain simply, the character data included in the frequency tabulation table T7 shall be character data illustrated in the list T1 in FIG. 1.

In the process at S201, the generating unit 1011 sequentially reads out data from the data file to be compressed. At this time, the generating unit 1011 reads out, for example, data with the bit length of one letter in a character code system used in the data file to be compressed. The generating unit 1011 detects, for example, a character code consistent with the read data from the frequency tabulation table T7, and increments a count value stored in a detected record. When a character string stored in the character-string list T8 is also included in the frequency tabulation table T7, in the readout of data from the data file to be compressed, the generating unit 1011 first determines whether it is the readout of a character string stored in the character-string list T8. In this determination, when having determined that it is the readout of a character string stored in the character-string list T8, the generating unit 1011 reads out the character string, and increments a count value in a record including the read character string in the frequency tabulation table T7. When having determined in the determination that it is not the readout of a character string stored in the character-string list T8, the generating unit 1011 reads out data with the bit length of one letter, and reflects a result of the readout in a count value of the frequency tabulation table T7.

When the frequency tabulating process at S201 has been finished, the generating unit 1011 sorts the frequency tabulation table T7 in order of frequency on the basis of a result of the tabulation reflected in the frequency tabulation table T7 (S202). Furthermore, the generating unit 1011 calculates the distribution of compressed code lengths on the basis of the distribution of the frequency of appearance of character data in the data file to be compressed (S203). The calculated compressed code length is stored in a code-length distribution table T9 illustrated in FIG. 15.

FIG. 15 illustrates an example of the code-length distribution table T9. In the example of FIG. 15, the number of character data is associated with each of code lengths 1 to 4. In the example of FIG. 15, the number of character data having a code length of 1 is 0, the number of character data having a code length of 2 is 1, the number of character data having a code length of 3 is 4, and the number of character data having a code length of 4 is 4.

The distribution of code lengths is calculated according to the distribution of the frequency of character data to be compressed. For example, with respect to each piece of character data to be compressed, the code length can be set on the basis of the frequency. For example, when the frequency of appearance in the file to be compressed is a frequency of 1/(2 to the n-th power) to the whole compressed file, an n-bit compressed code can be assigned.

When the process at S203 has been performed, the generating unit 1011 assigns a compressed code to each character data to be compressed (S204 to S210). When there are k types of character data to be compressed, the assignments of compressed codes to pieces of the first to k-th character data to be compressed are repeatedly performed, for example, in the sort order. Furthermore, how many times have the assignments of compressed codes been performed is denoted by i. An initial value of i is 1.

First, whether i is less than k is determined (S204). When i has reached k (NO at S204), the assignments of compressed codes and the generation of data structures of a compression/decompression dictionary for the character data to be compressed are complete, so the process of generating compression/decompression dictionary data is terminated (S211).

When i is less than k (YES at S204), the generating unit 1011 reads out the i-th character data of the character data to be compressed from the sorted frequency tabulation table (S205). Furthermore, the generating unit 1011 reads out code length corresponding to the read i-th character data from the code-length distribution table T9, and calculates a copy number C according to the read code length (S206). The copy number C indicates the number of reproductions of the read character data. The copy number C is to be represented by, for example, the power of (the predetermined length - the read code length) to the base 2.

Moreover, the generating unit 1011 generates a structure of a leaf of the character data read at S205 (S207). The structure of the leaf generated at S207 includes a character code of the i-th character data and the code length. Furthermore, the structure of the leaf includes a cross-check flag. S206 and S207 can be transposed.

Then, the generating unit 1011 reproduces as many copies of the structure of the leaf generated at S207 as the copy number C calculated at S206, and stores information obtained through the reproductions in a storage area of the storage unit 11 (S208). Then, the generating unit 1011 updates the position to write information according to the copy number C (S209). For example, when a structure of each leaf is 32 bits, the write position is advanced by 32 × the copy number C. Furthermore, the generating unit 1011 increments the value of i (S210), and again performs the process at S204.

FIG. 16 illustrates an example of a flowchart of the conversion process. When the process at step S103 illustrated in FIG. 11 has been performed (S300), first, the converting unit 1012 determines whether there is any character data remaining in the data file to be compressed (S301). Then, the converting unit 1012 reads out character data from the data file to be compressed (S302). The converting unit 1012 searches for character data coincident with the read character data by reference to the compression/decompression dictionary data T6 generated by the generating unit (S303). The converting unit 1012 calculates a compressed code on the basis of a storing place of a structure of a leaf in which the character data coincident with the read character data is stored, and writes the calculated compressed code in the storing place of the storage unit 11 (S304). The compressed code is obtained by dividing the storing place of the structure of the leaf (an offset from a beginning address of the data structure L of the leaf) by the data size of the structure of each leaf. When the process at S304 has been performed, the converting unit 1012 again performs the process at S301. The converting unit 1012 repeatedly performs the processes at S301 to S304 until there is no character data remaining in the data file to be compressed, and terminates the conversion process (S305).

When the process at step S103 in FIG. 11 has been finished, the compression unit 101 generates a compressed file including the compression/decompression dictionary data T6 generated by the generating unit 1011 and the compressed code string written in the storage unit 11 by the converting unit 1012 (step S104). When the process at step S104 has been performed, the file compression process is terminated (step S105).

Subsequently, the procedure of the decompression process performed in the computer 1 is explained.

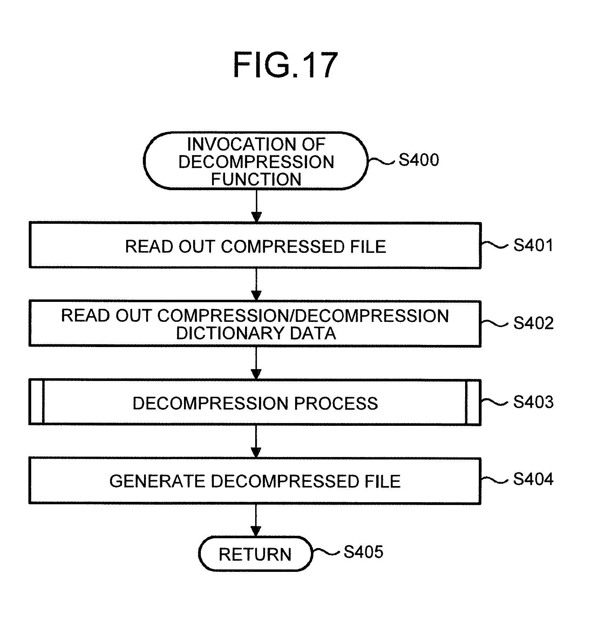

FIG. 17 illustrates an example of a flowchart of the decompression process performed by the decompression unit 102. When a decompression processing function has been invoked in response to the function of the application program 24 or an instruction input from a user (S400), the decompression unit 102 reads out a compressed file specified in the invocation of the decompression processing function from the storage unit 11 (S401). The decompression unit 102 expands compression/decompression data from the compressed file read at S401 into the storage unit 11 (S402). If it is the compressed data illustrated in FIG. 11, the compression/decompression data T6 illustrated in FIG. 6 is expanded. Then, the decompression unit 102 decompresses the compressed file through a process performed by the converting unit 1021 and the adjusting unit 1022 (S403).

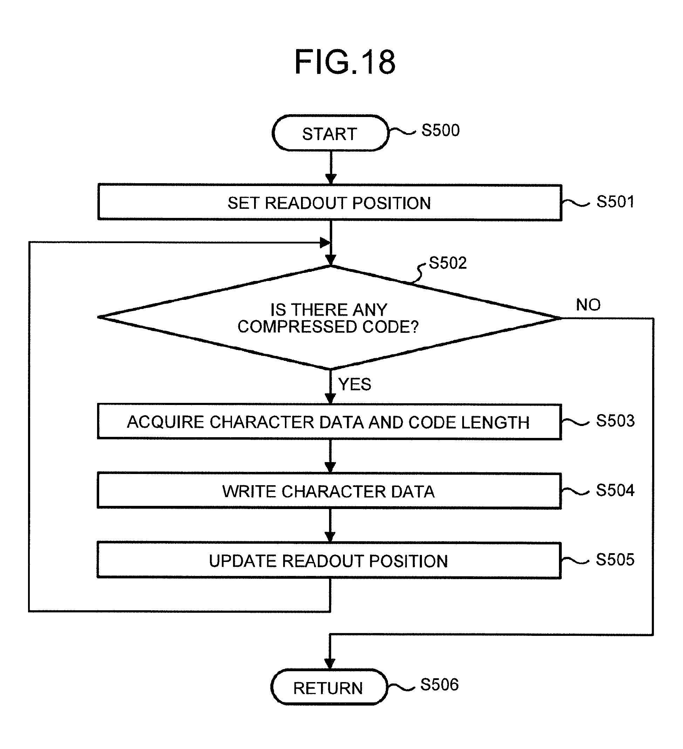

FIG. 18 illustrates an example of a flowchart of a conversion process of converting a compressed code into decompressed character data. When the decompression process at S403 in FIG. 17 has been performed (S500), the adjusting unit 1022 sets the readout position to the start point of a compressed code string in the compressed file read at S401 (S501). The converting unit 1021 determines whether the compressed code can be read out from the set readout position (S502). When the compressed code is not read out from the set readout position (all compressed codes have been read out) (NO at S502), the flow of the conversion process is terminated (S506).

When the compressed code can be read out in the process at S502 (YES at S502), the converting unit 1021 reads out a predetermined-length bit string from the set readout position. The predetermined length is, for example, the maximum bit length in the compressed code used in the compression. Furthermore, the converting unit 1021 reads out a data structure of a leaf located in the position specified by the read bit string in the compression/decompression dictionary data expanded at S402 (S503). At S503, first, a beginning address of a data structure L of a leaf is read out from a structure H of a header. The position specified by the read bit string is, for example, the position where an offset from the beginning address of the data structure L of the leaf is indicated by the data size of the data structure of each leaf times the read bit string. The data structure of the leaf read out in the process at S503 includes character data (decompressed character data) and the compressed code length.

Then, the converting unit 1021 writes the character data read out in the process at S503 in a storage area of the storage unit 11 (S504). Furthermore, the adjusting unit 1022 advances the readout position by a bit number indicated by the compressed code length read out in the process at S503 (S505). The above-described processes at S502 to S505 are repeatedly performed, thereby the compressed data is converted into a decompressed character string, and the converted decompressed character string is written in the storage unit 11.

When the process at S403 illustrated in FIG. 17 has been performed, the decompression unit 102 generates a decompressed file including a decompressed character data group written in the storage unit 11 by the converting unit 1021. When the decompressed file has been generated at S404, the flow of the decompression process illustrated in FIG. 17 is terminated (S405).

Furthermore, the procedure of the retrieval process performed in the computer 1 is explained.

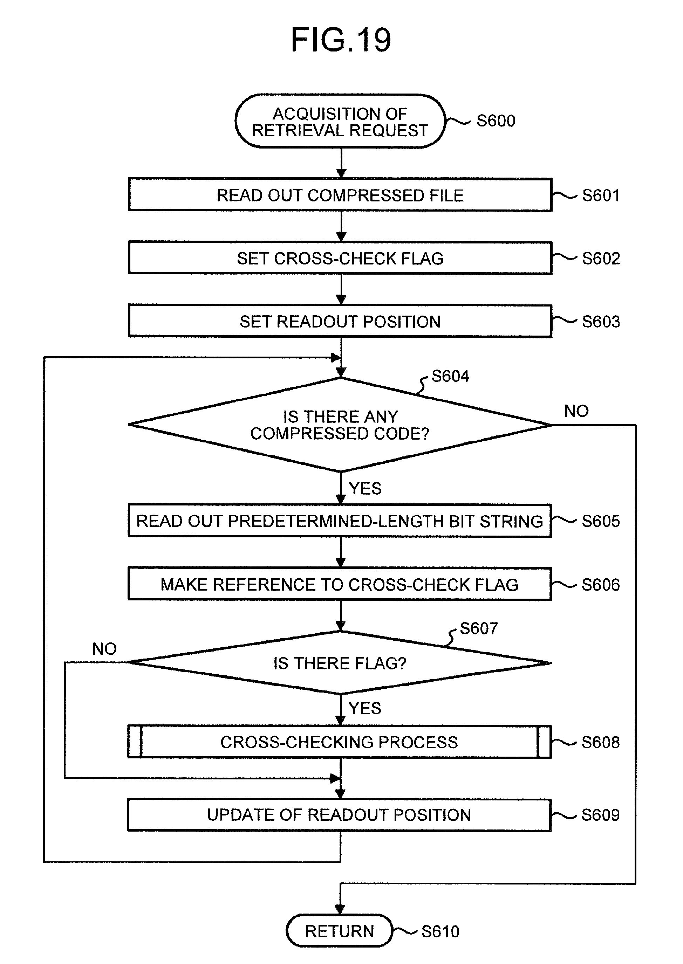

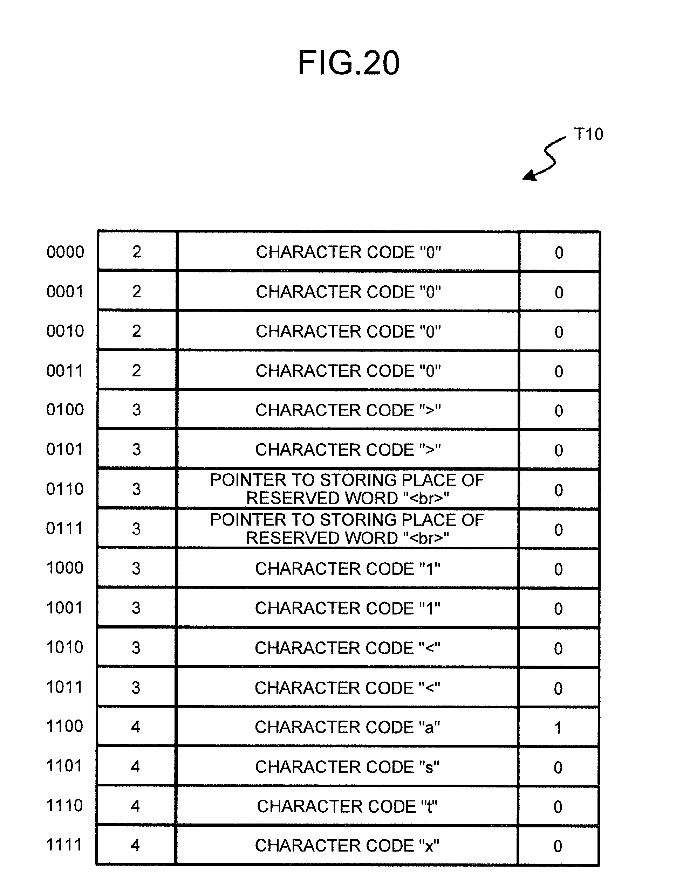

FIG. 19 illustrates an example of a flowchart of the retrieval process performed by the retrieval unit 103. When the retrieval unit 103 has received a retrieval request to extract a retrieval character string from the compressed file stored in the storage unit 11 (S600), a compressed file to be retrieved is read out (S601). Furthermore, the retrieval unit 103 analyzes the retrieval request received at S600, and sets a flag in a cross-check flag region of compression/decompression dictionary data T10 illustrated in FIG. 20 according to a result of the analysis (S602).

FIG. 20 illustrates the compression/decompression dictionary data T10 corresponding to the retrieval according to the present embodiment. As illustrated in FIG. 20, the compression/decompression dictionary data T10 has a cross-check flag region in addition to the compression/decompression dictionary data T6 illustrated in FIG. 6. In an initial state, bits of the cross-check flag region are all set to "0". When a bit of the cross-check flag region in the present embodiment is "0", it indicates "no cross-checking process required"; when a bit is "1", it indicates "a cross-checking process required".

The retrieval unit 103 sets, for example, a cross-check flag corresponding to the first character data of a retrieval character string included in the retrieval request received at S600. For example, if a retrieval character string is "apple", a cross-check flag corresponding to the character data "a" in the compression/decompression dictionary data T10 is set to "1" (see FIG. 20).

After the process at S602, the adjusting unit 1032 sets the position to read out a bit string from the compressed file in the same manner as the process performed by the adjusting unit 1022 at S501 (S603). Then, the search unit 1031 determines whether there is any not-yet-read data in the compressed file in the same manner as the process performed by the converting unit 1021 at S502 (S604). When there is no not-yet-read data in the compressed file (NO at S604), the flow of the retrieval process is terminated (S610).

When there is not-yet-read data in the compressed file (YES at S604), the search unit 1031 reads out a predetermined-length bit string from the compressed file (S605). The predetermined length is, for example, the maximum bit length in the compressed code used in the compression. Furthermore, the search unit 1031 makes reference to a cross-check flag of an area corresponding to the bit string read out in the process at S605 in the compression/decompression dictionary data T10 (S606). The search unit 1031 determines whether the cross-check flag referenced in the process at S606 is "0" or "1" (S607). When the cross-check flag has been set to "1" (YES at S607), the cross-checking unit 1033 performs a process of cross-checking against the retrieval character string (S608). When the process of cross-checking against the retrieval character string has been performed by the cross-checking unit 1033 or when the cross-check flag has been set to "0" in the determination at S607 (NO at S607), the adjusting unit 1032 updates the readout position in the same manner as the process performed by the adjusting unit 1022 at S505 (S609). The adjusting unit 1032 adjusts the readout position on the basis of the code length stored in the area referenced in the reference process at S606. After the process at S609, the process at S604 is again performed by the search unit 1031.

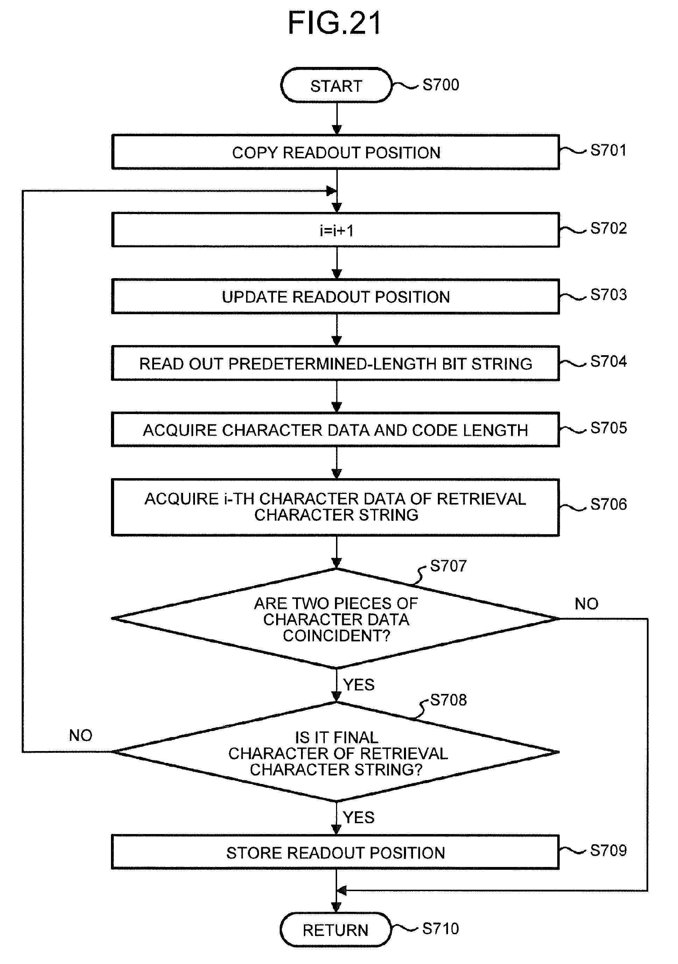

FIG. 21 illustrates an example of a flowchart of the cross-checking process performed by the cross-checking unit 1033. When the process at S608 in FIG. 19 has been performed (S700), the cross-checking unit 1033 performs the cross-checking process on the basis of copied readout position information. The cross-checking unit 1033 increments a value i of a counter which indicates what number character is cross-checked (S702). An initial value of i is 1. The cross-checking unit 1033 updates the readout position copied at S701 on the basis of the code length (S703). The first update of the readout position is performed on the basis of the code length of the area referenced at S606. The second and subsequent updates of the readout position are performed on the basis of the code length acquired in a process at S705 to be described later.

Then, the cross-checking unit 1033 reads out a predetermined-length bit string in the same manner as the process performed by the search unit 1031 at S605 (S704). The cross-checking unit 1031 reads out the character data and code length stored in a location specified by the bit string read at S704 in the compression/decompression dictionary data T10 (S705). Then, the cross-checking unit 1033 acquires the i-th character data of the retrieval character string (S706). Furthermore, the cross-checking unit 1033 determines whether the character data read at S705 coincides with the character data acquired at S706 (S707). When it has been determined in the determination at S707 that the two pieces of character data do not coincide with each other (NO at S707), the flow of the cross-checking process is terminated (S710), and the process at S609 in FIG. 19 is performed.

When having determined in the determination at S707 that the two pieces of character data coincide with each other (YES at S707), the cross-checking unit 1033 determines whether the character data acquired at S706 is the final character of the retrieval character string (S708). As a result of the determination at S708, when having determined that it is not the final character of the retrieval character string (NO at S708), the cross-checking unit 1033 again performs the process at S702.

As a result of the determination at S708, when having determined that it is the final character of the retrieval character string (YES at S708), the cross-checking unit 1033 stores the readout position as the position at which the character data coincident with the retrieval character string exists in the storage unit 11 (S709). As the readout position stored at S709, for example, either the copy source readout position copied at S701 or the readout position updated at S703 is used. When the readout position has been stored at S709, return to the flow of FIG. 19 (S710), the process at S609 in FIG. 19 is performed.

The cross-checking process illustrated in FIG. 19 can be also performed when the compression/decompression dictionary data T5 is used. However, in that case, in the process at S606, a pointer is read out by reference to the data structure KR of the root, and then a cross-check flag is checked by accessing the leaf data structure KL. In the same routine as the cross-checking process performed with use of the compression/decompression dictionary data T5, the cross-checking process using the compression/decompression dictionary data T6 can be implemented.

In the above-described embodiment, assume that 2000 types of character data are objects to be compressed by using a character code system in which one piece of character data is represented by 16 bits. Furthermore, assume that the code lengths of compressed codes assigned to pieces of character data to be compressed are up to 12 bits.

For example, a pointer used in the compression/decompression dictionary data T5 needs to determine a type of character data to be compressed, so a bit number enough to identify 2000 types or more is employed. When a memory which manages data in units of 1 byte is used, the root data structure KR is composed of a pointer stored in each 2-byte area. On the other hand, a 16-bit character code and its code length are stored in each of leaf data structures KL, a 3-byte area is provided. Therefore, the root data structure KR (the twelfth power of 2 × 2 bytes) and the leaf data structures KL (2000 × 2 bytes) require a storage area of about 14 kilobytes.

In the compression/decompression dictionary data T6, each of leaf data structures L is provided with a 3-byte storage area in the same manner as the leaf data structures KL. Therefore, a storage area of about 12 kilobytes calculated by the twelfth power of 2 × 3 bytes is employed.

In the above example, if the character data to be compressed is about 1330 characters, the data size of the compression/decompression dictionary data T6 is smaller than the compression/decompression dictionary data T5.

The embodiment explained above is just an example, and can be appropriately modified within the scope of the invention. Furthermore, as for further detailed contents of the processes explained above, technologies well known to those skilled in the art are used appropriately.

### Reference Signs List

- 1: COMPUTER
- 2: BASE STATION
- 3: NETWORK
- 1a: COMPUTER
- 1b: COMPUTER
- 10: CONTROL UNIT
- 11: STORAGE UNIT
- 101: COMPRESSION UNIT
- 102: DECOMPRESSION UNIT
- 103: RETRIEVAL UNIT
- 1011: GENERATING UNIT
- 1012: CONVERTING UNIT
- 1021: CONVERTING UNIT
- 1022: ADJUSTING UNIT
- 1031: SEARCH UNIT
- 1032: ADJUSTING UNIT
- 1033: CROSS-CHECKING UNIT

## Claims

1. A storage program causing a computer to execute:
storing character data to be compressed in respective storing places specified by a plurality of types of predetermined-length bit strings including a compressed code assigned to the character data within a storage area where the storing places are specified by the predetermined-length bit strings.

2. The storage program according to claim 1, wherein
code length of the compressed code is shorter than the predetermined-length bit strings.

3. The storage program according to claim 1 or 2, wherein
code length of another compressed code assigned to another piece of character data to be compressed is different from the code length of the compressed code assigned to the character data, and the code length of the compressed code is stored in a manner associated with the character data.

4. The storage program according to any one of claims 1 to 3, wherein
the plurality of types of predetermined-length bit strings include the compressed code in a common bit location, and differ in a redundant bit string except for the compressed code in each predetermined-length bit string.

5. The storage program according to any one of claims 1 to 4, wherein
there are as many different types of predetermined-length bit strings as the number of compressed codes.

6. The storage program according to any one of claims 1 to 5, the storage program causing the computer to further execute:
converting, when the character data has been included in a file to be compressed, the character data in the file into the compressed code.

7. A storage method for causing a computer to execute:
storing character data to be compressed in respective storing places specified by a plurality of types of predetermined-length bit strings including a compressed code assigned to the character data within a storage area where the storing places are specified by the predetermined-length bit strings.

8. A storage device comprising:
a storage unit that includes a storage area where a storing place is specified by a predetermined-length bit string; and
a control unit that stores character data to be compressed in respective storing places specified by a plurality of types of predetermined-length bit strings including a compressed code assigned to the character data within the storage area.

9. A decompression program causing a computer to execute:
when a plurality of types of predetermined-length bit strings including a common compressed code are read out from a storage area where decompressed character data corresponding to the compressed code and code length of the compressed code have been stored in respective storing places specified by the predetermined-length bit strings including the compressed code from readout position in a compressed file, reading out the decompressed character data and the code length from a storing place specified by a read predetermined-length bit string;
converting the predetermined-length bit string read out from the compressed file into the decompressed character data; and
adjusting the readout position on the basis of the code length.

10. The decompression program according to claim 9, wherein
the predetermined-length bit strings read out from the compressed file and the plurality of types of predetermined-length bit strings include the compressed code in a common bit location, and differ in a redundant bit string except for the compressed code from one another.

11. The decompression program according to claim 9 or 10, wherein
there are as many different types of predetermined-length bit strings as the number of compressed codes.

12. The decompression program according claim 10 to 11, wherein
at least part of the redundant bit string is read out in the next readout of a predetermined-length bit string by adjusting the readout position.

13. A decompression method for causing a computer to execute:
when a plurality of types of predetermined-length bit strings including a common compressed code are read out from a storage area where decompressed character data corresponding to the compressed code and code length of the compressed code have been stored in respective storing places specified by the predetermined-length bit strings including the compressed code from readout position in a compressed file, reading out the decompressed character data and the code length from a storing place specified by a read predetermined-length bit string;
converting the predetermined-length bit string read out from the compressed file into the decompressed character data; and
adjusting the readout position on the basis of the code length.

14. A decompression device comprising:
a storage unit that includes a storage area where decompressed character data corresponding to a common compressed code and code length of the compressed code have been stored in respective storing places specified by a plurality of types of predetermined-length bit strings including the compressed code;
a readout unit that reads, when the predetermined-length bit strings including the compressed code are read out from readout position in a compressed file, the decompressed character data and the code length from a storing place specified by a read predetermined-length bit string out to the storage unit;
a converting unit that converts the predetermined-length bit string read out from the compressed file into the decompressed character data; and
an adjusting unit that adjusts the readout position on the basis of the code length.
